# EUROPEAN PATENT APPLICATION

(11) **EP 1 001 490 A2**
(43) Date of publication of application: **17.05.2000**
(21) Application number: 99122291.0
(22) Date of filing: 09.11.1999
(51) Int. Cl.: H01R 4/24

(54) **Network services terminating point conductor insertion and test circuit tool**

(30) Priority: 09.11.1998 US 107656 P; 05.11.1999 US
(71) Applicant: PORTA SYSTEMS CORPORATION, Syosset, NY 11791 (US)
(72) Inventor: Black, Andrew, South Wales, UKNP65TA (GB); Roy, Anthony, New York 11562 (US)
(74) Representative: LOUIS, PÖHLAU, LOHRENTZ & SEGETH

(57) **Abstract**

An apparatus for assisting a telephone service subscriber in connecting telephone equipment to a network services terminating point and in testing telephone service to the terminating point. A network services terminating point conductor insertion and test circuit tool allows a subscriber to insert a conductor to a proper depth in a network services terminating point module without damaging the module. The telephone service provider's line can be tested to the point of the network services terminating point by inserting the test circuit into the module.

## Description

### CROSS-REFERENCE TO RELATED APPLICATIONS

This application claims the benefit of United States Provisional Patent Application Serial No. 60/107,656 filed November 9, 1998, entitled "Network Services Terminating Point Conductor Insertion and Test Circuit Tool," the disclosure of which is incorporated herein by reference.

### BACKGROUND OF THE INVENTION

### FIELD OF THE INVENTION

This invention relates to an apparatus for assisting a telephone service subscriber in connecting telephony communication equipment lines to a network services terminating point and in testing a telephone service provider's line connected to that terminating point.

### DESCRIPTION OF THE PRIOR ART

Since the changes in the regulation of the telephone industry, subscribers rarely lease telephony communications equipment from the telephone service provider. More often, subscribers will purchase their own equipment and connect it to telephone lines provided by the telephone service provider.

Telephone service providers often provide subscribers with service to a central location in a subscriber's home or building. This central point is called the Network Services Terminating Point (NSTP). Subscribers can then connect the telephone equipment located throughout their homes or buildings to the NSTP. The NSTP contains a module which can accept a plurality of conductors from the telephone service provider and an equal number of mating pairs which correspond to the telephony communications equipment within the subscribers' homes or buildings.

These modules accept a plurality of mated pairs of conductors. The NSTP module is constructed to accept conductors by pushing the conductors between two resilient module contacts which spread apart to accept the conductor and then close together, thereby frictionally holding the conductor in place. A screwdriver can be used to insert the conductors into the module. The screwdriver, however, will often bend the module contacts resulting in a less than perfect connection between a conductor and a module contact.

Typically, telephone service providers are responsible for maintenance on the telephone line up to the NSTP. Telephone service providers normally do not service the subscribers' privately owned equipment. It is, therefore, important for the telephone service providers to be able to determine whether a problem exists on their side of the NSTP or on the subscribers' side of the NSTP. If the problem is on the telephone service providers' side of the NSTP, a service call will be made to correct the problem. If, however, the problem is on the subscribers' side of the NSTP, a service call will not be made and the subscribers must have the problem repaired themselves.

In order to determine which side of the NSTP a problem is on, it is necessary to disconnect the subscribers' telephony communications equipment and place a test circuit in place of the equipment. In the past, this meant disconnecting wires and attaching the wires to the test circuits. For complex systems with many incoming lines this was not an easy task. Wires could be erroneously connected giving false results. Further, damage to the system could result from connecting the wrong wires together.

Telephone lines were also checked by installing a special test jack connected between the telephone service provider's telephone line and the subscriber's privately owned telephone equipment. To conduct a test, an available conventional telephone set was connected by plugging it into the test jack. The test jack was arranged to disconnect the subscriber's privately owned telephone equipment when the test telephone set was plugged into the test jack. The telephone service provider's line was thereby isolated from the subscriber's equipment. If the subscriber received a dial tone and was able to dial a number, the problem was in the subscriber's equipment. If, however, the subscriber was unable to detect a dial tone or operate the telephone, the problem was in the telephone line and a service call would be requested.

The addition of a test jack adds considerable expense, complexity, and size to the telephone system. Since a test jack must exist for each line, a home or building with multiple lines would require numerous test jacks, thereby adding expense and size to the system. Further, the test jack must be connected in series between the NSTP and the subscriber's equipment. This requires the subscriber to connect wires from the NSTP to the test jack and from the test jack to the subscriber's telephone equipment.

The present invention solves the problems associated with the prior art discussed above.

### OBJECTS AND SUMMARY OF THE INVENTION

It is an object of the present invention to provide a single tool which can be used to insert conductors in a module and which also can be used to disconnect a subscriber's telephony equipment and insert a test circuit.

It is a further object of the present invention to provide a tool which is shaped so that the insertion tool and the test circuit are aligned to facilitate proper insertion of the conductor by the subscriber.

It is an even further object of the present invention to provide a system which facilitates the connecting and testing of telephone service provider lines and telephone equipment.

It is an even further object of the present invention to provide a system in which a subscriber's telephone equipment can easily be connected to a telephone service provider's line at a central location and the telephone service provider's line can be checked from the same central location.

In accordance with one form of the present invention, an NSTP conductor insertion and test circuit tool comprises a housing, a test circuit located within the housing, the test circuit including a resistor and capacitor connected in series, a test circuit board extending from the test circuit and the housing, the test circuit board including a trace connected to the resistor and a trace connected to the capacitor, and a conductor insertion implement extending from the housing and shaped to receive a conductor and insert the conductor to a pre-determined depth into an NSTP module.

The test circuit board and conductor insertion implement may extend from the housing at any angle from one another. The test circuit and conductor insertion implement may also be orthogonal or co-planar to one another.

In a further embodiment the test circuit board will have a second set of traces and a second test circuit. The second set of traces will be on the opposite face of the test circuit board and be similarly connected to the second test circuit's resistor and capacitor.

In an even further embodiment, a telephone system combines a plurality of conductors from a telephone service provider, a plurality of conductors from telephone equipment, a sealable subscriber access box containing an NSTP module, and an NSTP conductor insertion and test circuit tool. The tool may be moveably connected to the subscriber access box and be stored within the subscriber access box.

These and other objects, features, and advantages of the present invention will be apparent from the following detailed description of illustrative embodiments thereof, which are to be read in connection with the accompanying drawings.

### BRIEF DESCRIPTION OF THE DRAWINGS

Figure 1 is a pictorial diagram of the side of an NSTP module used to connect the line from the telephone provider to the subscriber's telephony communications equipment.
Figure 2 is a pictorial diagram of the side of the NSTP module of Figure 1 with a test circuit inserted between a pair of contacts connecting the line from the telephone provider to the subscriber's telephony communication equipment.
Figure 3 is a pictorial diagram of the front of the NSTP module of Figure 1 with a test circuit inserted between the contacts as in Figure 2.
Figure 4 is a pictorial diagram of one embodiment of an NSTP conductor insertion and test circuit tool formed in accordance with the present invention.
Figure 5 is a pictorial diagram of another embodiment of the NSTP conductor insertion and test circuit tool formed in accordance with the present invention.
Figure 6 is a pictorial diagram of another embodiment of the NSTP conductor insertion and test circuit tool formed in accordance with the present invention.
Figure 7 is a pictorial diagram of the operational end of an NSTP insertion implement formed in accordance with the present invention.
Figure 8 is a pictorial diagram of an embodiment of an NSTP system formed in accordance with the present invention.

### DETAILED DESCRIPTION OF THE PREFERRED EMBODIMENTS

Telephone providers place subscriber access boxes at the network services terminating point located in a subscriber's home or building. The subscriber access boxes typically receive twenty pairs of lines from the telephone provider and twenty mated pairs from the subscriber's telephone equipment. The subscriber can then access the box and connect telephone equipment to the lines by inserting conductors connected to the telephone equipment into an NSTP module within the box. The NSTP module also receives the conductors of the twenty lines from the telephone service provider.

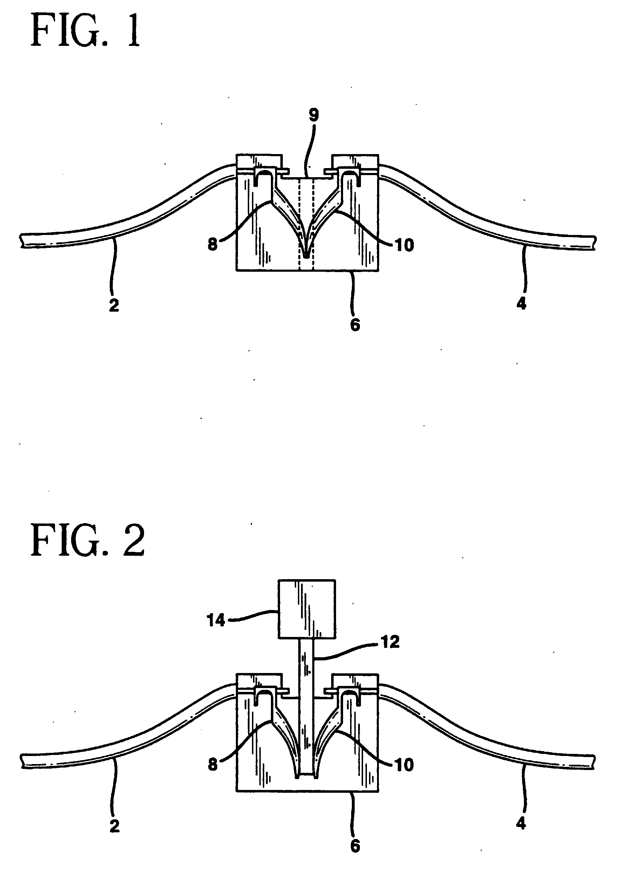

Referring initially to Figure 1, the NSTP module will be described in detail. The module includes a non-conductive housing 6 and pairs of resilient conducting contacts 8, 10. The contacts 8, 10 are selectively in electrical contact due to their resiliency and pressing against each other. The contacts 8, 10 are arranged to accept conductors 2, 4, respectively. The pictorial diagram in Figure 1 illustrates a single pair of contacts. Typically, the module will include ten or twenty pairs of contacts in a row. The module also includes a slot 9 in which a test circuit could be inserted from above.

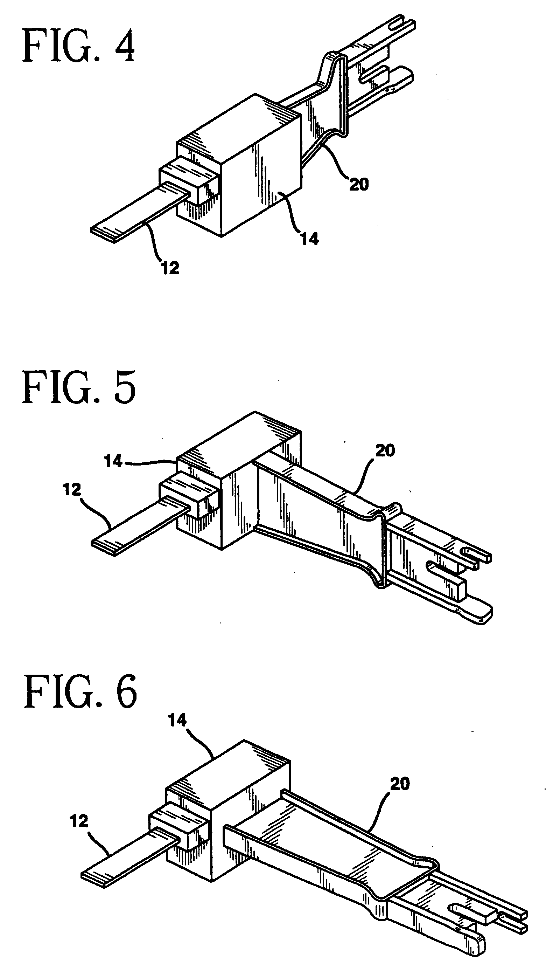

The subscriber must use a tool to properly place the conductor in the module. Referring to Figures 4, 5, 6, and 7, the insertion tool will be described in detail. The insertion implement 20 is arranged to hold the conductor and is shaped to slide the conductor into the NSTP module, thereby placing it in contact with the contact 8, 10 of Figure 1. The insertion implement 20 is shaped so that when the conductor is fully inserted into the module, the insertion tool is against the housing 6 and cannot be pushed any further. This ensures that the contacts 8, 10 will not be bent by excessive force.

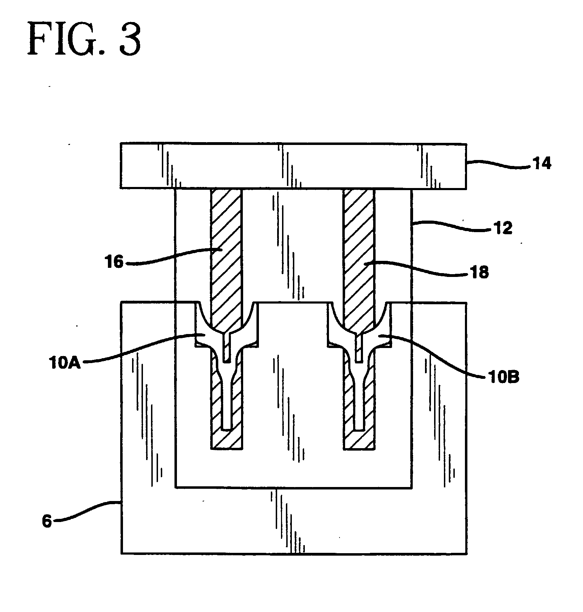

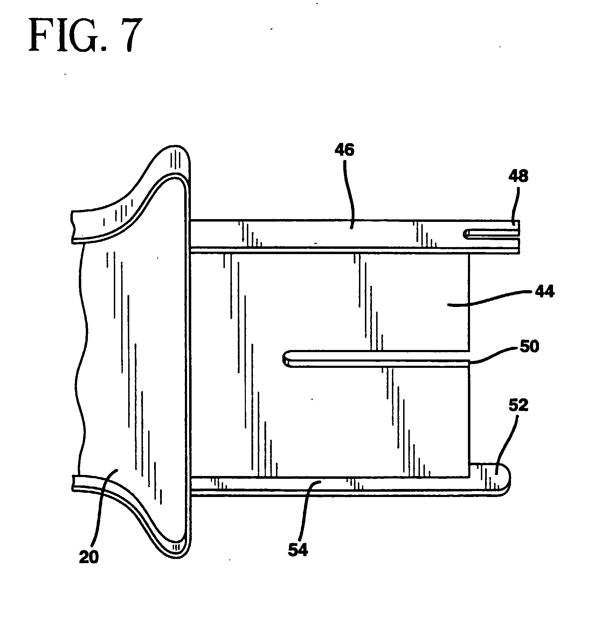

Figures 4, 5, and 6 are perspective views illustrating three embodiments of the conductor insertion and test circuit tool. The embodiment in Figure 4 includes a housing 14 which includes a series circuit comprising a resistor and a capacitor. Extending from the housing 14 are the test circuit board 12 and the conductor insertion implement 20. A more detailed pictorial diagram of the operational end of the conductor insertion implement is illustrated in Figure 7. The operational end of the conductor insertion implement includes a top wall 46, a middle wall 44, and a bottom wall 54. The three walls 44, 46, 54 extend from the distal end of the conductor insertion implement 20. At its distal end, the top wall forms prongs 48 which are shaped to accept and frictionally hold a conductor. Middle wall 44 connects the top wall 46 and the bottom wall 54. Middle wall 44 includes a slot 50 which is positioned to straddle the module contacts 10A, 10B (shown in Figure 3) when inserting a conductor. The bottom wall 54 is connected to the middle wall and terminates in a stop 52. The stop 52 is the rounded distal end of the bottom wall 54.

In operation, a conductor is slid between the prongs 48 and along the distal end of the middle wall 44 until it is stopped by the stop 52. The conductor insertion tool is then aligned with the NSTP module and pressure is applied pushing the conductor into the module. The contacts in the module are separated and the conductor is slipped between the contacts which close around the conductor, thereby frictionally holding the conductor in place. The slot 50 allows the conductor to be pushed into the module contacts without bending the contacts. As the module contacts close around the conductor, they pass through slot 50.

The stop 52 controls the length of the conductor to be inserted. The length of the middle wall 44 and the length of the slot 50 control the depth to which the conductor is inserted into the module.

The embodiment shown in Figure 5 includes the housing 14, the test circuit board 12, and the conductor insertion implement 20. The test circuit board 12 and the conductor insertion implement 20 extend from the housing 14 in transverse directions, preferably at a 90° angle from one another. The plane in which the conductor insertion implement 20 resides is also preferably orthogonal to the plane in which the circuit board 12 resides. In an alternative embodiment, the plane in which the conductor insertion implement 20 resides is parallel to the plane in which the circuit board 12 resides. Preferably, in this alternative embodiment, the conductor insertion implement 20 and the circuit board 12 are co-planar.

A preferred embodiment of the tool is shown in Figure 6. The embodiment shown in Figure 6 is similar to the embodiment shown in Figure 5 except that the conductor insertion implement 20 is co-planar to the test circuit board 12. This makes it easier to give the subscriber clear directions on which way to insert a conductor into the module by referring to the pointing direction of the test circuit board and also allows for a more comfortable grip of the tool.

In operation, the telephone service provider installs the NSTP module in a subscriber's home or building and provides a telephone line to the module. Referring to Figure 1, the telephone line 4 is inserted into the module and is frictionally held in place by contact 10. The telephone line 4 is thereby electrically coupled to contact 10. Contact 10 is shaped so that it presses against similarly shaped contact 8 forming a juncture. The telephone line 4 is thus electrically coupled to contact 8. The subscriber's telephone equipment is connected to the other side of the module. An equipment line 2 is inserted into the module using the conductor insertion implement. Once the equipment line 2 is connected to the module, the telephone line 4 will be electrically coupled to the telephone equipment attached to the equipment line and the equipment may now be used.

If a problem develops in the use of the telephone equipment, the telephone subscriber can test the line up to the NSTP by disconnecting the telephone equipment and inserting a test circuit in place of the equipment. A subscriber can perform both tasks by inserting a test circuit board which separates the contacts 8, 10 connecting the telephone service provider's lines with the subscriber's telephone equipment.

Referring now to Figures 2 and 3, the testing of the telephone line will be described in detail. The module is shown with a test circuit inserted in the slot 9. The slot 9 is positioned directly over the juncture of the contacts 8, 10. Inserting the test circuit in the slot 9 thereby separates the contacts 8, 10. The test circuit is comprised of a test circuit board 12 and a resistor serially connected to a capacitor. The test circuit board has a front face and a back face. The front face includes two conductive traces which extend into the housing 14. One trace is connected to the resistor and the other trace is connected to the capacitor. Preferably, the back face is entirely insulative material. It is preferable that the resistor be about 470 kilo ohms (KΩ) and be capable of dissipating about 1/4 watt of power. It is also preferable that the capacitor be about 1.8 micro farads (µF) and have a maximum voltage rating of about 250 volts.

Figure 3 is a pictorial diagram illustrating the front face of the test circuit board when inserted into the module. Figure 3 shows two contacts 10A, 10B which would be connected to contacts 8A, 8B (not shown) if the test circuit board were removed. The trace 16 on the front face of the circuit board is connected to the test circuit resistor and the trace 18 is connected to the test circuit capacitor. The traces 16, 18 are arranged on the circuit board 12 to align with the contacts 10A, 10B. Preferably, once inserted, the trace 16 is electrically coupled to contact 10A which is connected to a tip line of the telephone line. The trace 18 is electrically coupled to contact 10B which is connected to a ring line of a telephone line. Since the back face of the circuit board is insulative material, the subscriber's telephone equipment is completely isolated from the telephone service provider's line.

The telephone company can now send a signal through the line to the test circuit of known impedance to determine if the telephone line is in operation up to the NSTP. If the telephone line is working properly, the test circuit is removed and the equipment at the home or building must be repaired. If, however, the telephone provider determines their line has malfunctioned, the test circuit is removed and a service call is made by the telephone provider.

The NSTP conductor insertion and test circuit tool allows a subscriber to connect equipment to the NSTP and test the connection using a single dual purpose tool.

In an alternative embodiment, the back face of the circuit board contains two conductive traces similarly aligned with the module's contacts. One of the traces is connected to one end of a second series circuit consisting of a resistor and capacitor. The other trace is connected to the other end of the second series. The resistor and capacitor would, preferably, have the same values as those components in the first embodiment. Thus, in this further embodiment, the test circuit includes two separate series arrangements of resistors and capacitors, one arrangement being connected to the traces on the front face of the circuit board and the other arrangement being connected to the traces on the back face of the circuit board. By placing identical test circuits on both sides of the circuit board, the subscriber can insert the test circuit board either way and still obtain accurate results. Thus, the subscriber does not have to worry about how the test circuit board is oriented when inserting the test circuit board into the module.

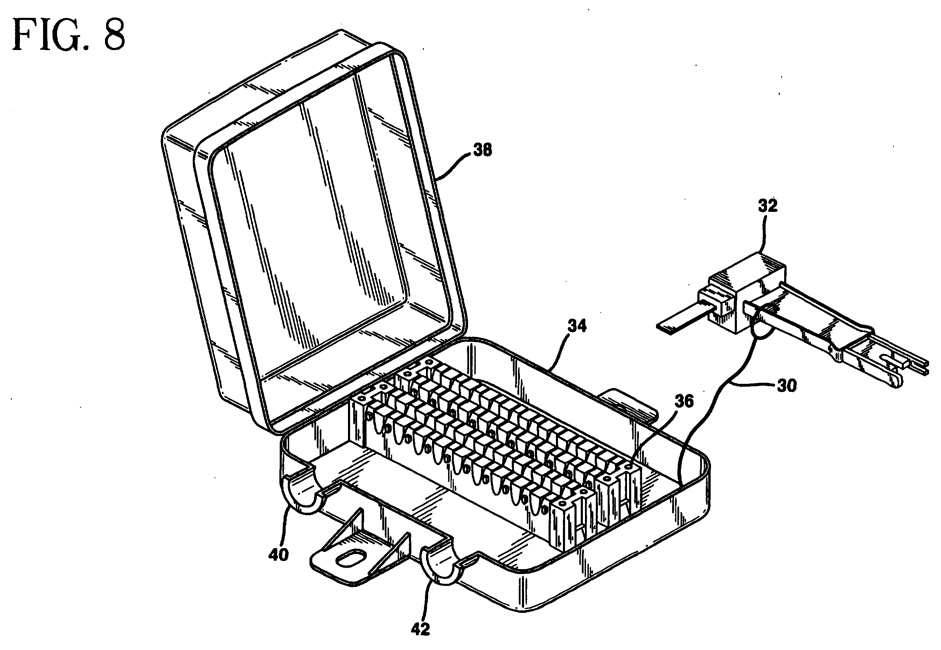

Figure 8 is a pictorial diagram of an NSTP system. The NSTP includes a module 36 mounted to a case 34 with a cover 38 which may be positioned to an open or closed position. The case 34 includes openings 40 and 42 to accept equipment lines and telephone lines. A conductor insertion and test circuit tool 32 is attached to the case 34 by a tether 30. Typically, the NSTP system would be installed by the telephone provider and telephone lines would be connected to the module 36. The subscriber is then able to connect telephone equipment lines to the module 36 using the tool 32. If a problem develops, the telephone line can be tested by the subscriber by inserting the test circuit of the tool 32 into the module.

The NSTP system allows subscribers to perform installation and troubleshooting procedures from a central location using a single tool which is included with and stored in the system. The tool 32 is able to be stored in the case 34 by dimensioning the case 34 to be able to receive the tool 32 while the case 34 is open and to enclose the tool 32 for storage when the case 34 is closed.

Although the illustrative embodiments of the present invention have been described herein with reference to the accompanying drawings, it is to be understood that the invention is not limited to those precise embodiments, and that various other changes and modifications may be effected therein by one skilled in the art without departing from the scope or spirit of the invention.

## Claims

1. A network services terminating point conductor insertion and test circuit tool comprising:
a) a housing;
b) a test circuit located within the housing and having a first end and a second end;
c) a test circuit board, the test circuit board extending from the housing and including a first trace and a second trace positioned to align with contacts of a network services terminating point module, the first trace connected to the first end of the test circuit and extending across the test circuit board, the second trace connected to the second end of the test circuit and extending across the test circuit board; and
d) a conductor insertion implement, the conductor insertion implement extending from the housing and shaped to receive a conductor, the conductor insertion implement arranged to insert the conductor a predetermined depth into the network services terminating point module.

2. The network services terminating point conductor insertion and test circuit tool as defined by Claim 1, wherein the test circuit is comprised of a resistor and capacitor connected in series.

3. The network services terminating point conductor insertion and test circuit tool as defined by Claim 1, wherein the test circuit board and the conductor insertion implement extend from the housing at a 90° angle from one another.

4. The network services terminating point conductor insertion and test circuit tool as defined by Claim 1, wherein the test circuit board and conductor insertion implement extend from opposite sides of the housing.

5. The network services terminating point conductor insertion and test circuit tool as defined by Claims 1, 3 or 4, wherein the test circuit board is orthogonal to the conductor insertion implement.

6. The network services terminating point conductor insertion and test circuit tool as defined by Claims 1, 3 or 4, wherein the conductor insertion implement resides in a first plane and the test circuit board resides in a second plane, the first and second plane being parallel to one another.

7. The network services terminating point conductor insertion and test circuit tool as defined by Claims 1, 3 or 4, wherein the test circuit board is co-planar to the conductor insertion implement

8. A network services terminating point conductor insertion and test circuit tool comprising:
a) a front test circuit and a back test circuit, the front test circuit and back test circuit located within a housing, the front test circuit including a front resistor and a front capacitor forming a front serial circuit having a front resistor end and a front capacitor end, the back test circuit including a back resistor and a back capacitor forming a back serial circuit having a back resistor end and a back capacitor end;
b) a test circuit board having a front and a back, the test circuit board extending out from the housing, the front of the test circuit board including a first front trace and a second front trace, the first front trace connected to the front resistor end of the front serial circuit and the second front trace connected to the front capacitor end of the front serial circuit the first back trace connected to the back resistor end of to back serial circuit and the second back trace connected to the back capacitor end of the back serial circuit; and
c) a conductor insertion implement, the conductor insertion implement extending from the housing and shaped to receive a conductor, the conductor insertion implement arranged to insert the conductor to a pre-determined depth in a network services terminating point module.

9. In a telephone system, the combination of:
a) a plurality of conductors for connection to a telephone service provider;
b) a plurality of conductors for connection to a telephone subscriber's equipment;
c) a sealable network services terminating point module housing containing a network services terminating point module, the module shaped to receive a plurality of conductors from the telephone service provider and telephone equipment; and
d) a network services terminating point conductor insertion and test circuit tool for inserting the conductors into the module and for testing the connection of the module to the telephone service provider.

10. A telephone system as defined by Claim 9, wherein the network services terminating point conductor insertion and test circuit tool is attached to the network services terminating point module housing by a tether.

11. A telephone system as defined by Claim 9, wherein the network services terminating point module housing is dimensioned to receive and enclose the network services terminating point conductor insertion and test circuit tool.
